# DEMANDE DE BREVET EUROPEEN

(11) **EP 2 463 809 A1**
(43) Date de publication de la demande: **13.06.2012**
(21) Numéro de dépôt: 10194068.2
(22) Date de dépôt: 07.12.2010
(51) Int. Cl.: G06K 19/077

(54) **Carte électronique à contact électrique comprenant une unité électronique et/ou une antenne**

(71) Demandeur: NagraID S.A., 2301 La Chaux-de-Fonds (CH)
(72) Inventeur: Droz, François, 2035 Corcelles (CH)
(74) Mandataire: Surmely, Gérard

(57) **Abrégé**

Carte électronique (42) comprenant une unité électronique et/ou une antenne incorporée dans le corps (12) de cette carte et un connecteur externe (32) présentant, d'une part, des plages de contact externes (4) agencées sur une face externe d'un support formant le connecteur et, d'autre part, des plages de contact internes (34) agencées sur une face interne (33) du support opposée à la face externe. Au moins une première pluralité de plages de contact internes du connecteur sont respectivement reliées électriquement à une deuxième pluralité de plages de contact (16A) qui apparaissent à une surface (15) d'une cavité (14) prévue dans le corps de la carte et qui sont reliées électriquement à l'unité électronique et/ou à l'antenne, cette cavité définissant un logement pour le connecteur qui adhère à la surface de cette cavité au moyen d'une colle située entre cette surface et la face interne du connecteur. Cette carte électronique est caractérisée par le fait que les plages de contact internes de la première pluralité de plages de contact internes sont respectivement soudées aux plages de contact de ladite seconde pluralité de plages de contact.

## Description

### Domaine de l'invention

La présente invention concerne le domaine des cartes électroniques, notamment du type bancaire, comprenant une unité électronique et/ou une antenne incorporée dans le corps de cette carte et un connecteur externe présentant, d'une part, des plages de contact externes agencées sur une face externe d'un support formant ce connecteur et, d'autre part, des plages de contact internes agencées sur une face interne du support opposée à la face externe. Au moins une pluralité de plages de contact internes du connecteur sont respectivement reliées électriquement à une deuxième pluralité de plages de contact correspondantes qui apparaissent dans une cavité prévue dans le corps de la carte, cette cavité définissant un logement pour le connecteur qui adhère à la surface de cette cavité au moyen d'une colle située entre cette surface et la face interne du connecteur.

### Arrière-plan technologique

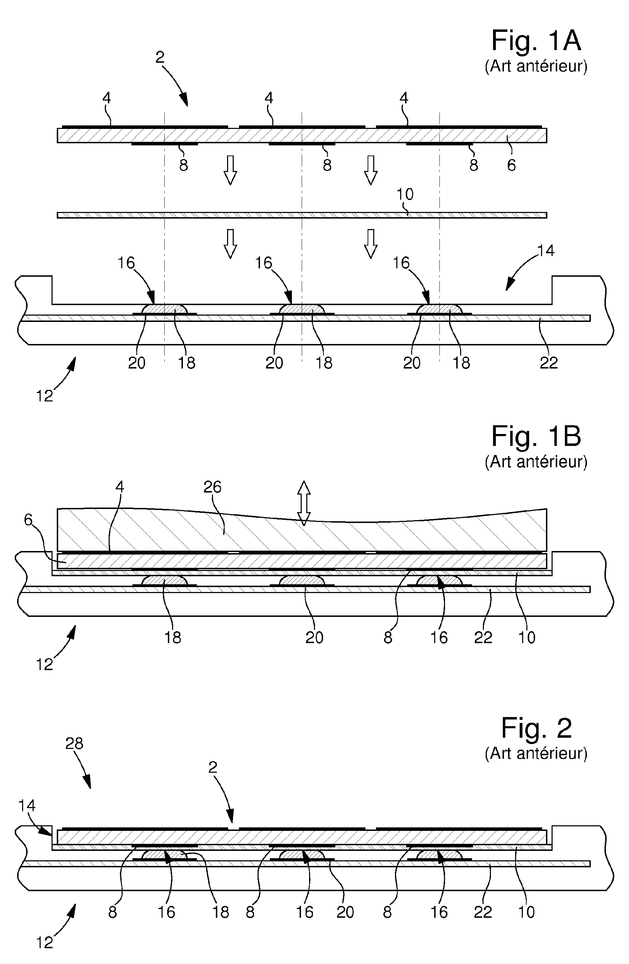

Aux figures 1A et 1B est représenté schématiquement un procédé industriel classique de fabrication de cartes électroniques du type mentionné ci-dessus. On fabrique premièrement un connecteur 2 et un corps de carte 12 présentant une cavité 14 destinée à recevoir le connecteur 2. Ce connecteur comprend des plages de contact externes 4 agencées sur une face externe du support 6 et des plages de contact internes 8 agencées sur la face interne de ce support. Les plages externes 4 sont reliées électriquement aux plages internes 8 par des moyens connus de l'homme du métier. Le corps de carte 12 comprend une pluralité de plages de contact 16 destinées à être connectées aux plages 8. Ces plages 16 apparaissent à une surface horizontale (parallèle au plan général de la carte) de la cavité 14. Chaque plage de contact 16 est formée d'une brasure 18, notamment de l'étan, déposée sur une plage interne 20 du corps de carte 12. Les plages 20 sont agencées à la surface d'un support 22 associé à une unité électronique et/ou une antenne incorporée dans le corps de carte 12 et reliée électriquement à ces plages 20 via un circuit imprimé.

Un film de colle conductrice 10 et le connecteur 2 sont apportés dans la cavité 14 du corps de carte 12, le film de colle 10 étant agencé entre le fond de la cavité 14 et le connecteur 2. A l'aide d'une presse chauffante 26, le connecteur est fixé au corps de carte 12. A la figure 2 est représentée partiellement une carte 28 obtenue par le procédé de l'art antérieur décrit ici. Selon ce procédé classique, la colle conductrice 10 forme une couche entre les plages de contact internes 8 et les plages de contact 16 situées au niveau de la surface horizontale définissant le fond de la cavité 14.

Divers tests effectués sur les cartes du type de celle de la figure 2 et l'analyse des cartes défectueuses retournées par divers utilisateurs montrent que les connections électriques entre le connecteur externe 2 et les plages de contact 16 apparentes dans la cavité 14 ne sont pas fiables. Les cartes électroniques, notamment les cartes bancaires, subissent généralement diverses contraintes mécaniques étant donné que les utilisateurs les portent généralement soit dans leur portemonnaie, soit dans un porte-carte flexible. Les flexions ou les torsions subies par les cartes 28 avec des paires de plages de contact collées l'une à l'autre peuvent engendrer un décollement local au niveau de ces plages de contact ou même des interstices qui rompent alors la connexion électrique. Ainsi, les cartes électroniques de l'art antérieur du type considéré ont un problème de longévité à cause de l'interface de colle conductrice prévue entre les plages de contact internes du connecteur 2 et les plages de contact correspondantes 16 du corps de carte 12.

### Résume de l'invention

Le but de la présente invention est de fournir une carte électronique, du type défini dans le domaine de l'invention, qui pallie les inconvénients de l'art antérieur et un procédé de fabrication d'une telle carte électronique.

A cet effet, la présente invention concerne une carte telle que définie précédemment dans le domaine de l'invention et caractérisée par le fait que les plages de contact internes de la première pluralité de plages de contact internes du connecteur sont respectivement soudées aux plages de contact de la seconde pluralité de plages de contact apparaissant à la surface de la cavité prévue dans le corps de la carte.

D'autre part, la présente invention concerne un procédé de fabrication d'une carte électronique comprenant au moins une unité électronique et/ou une antenne incorporée dans le corps de cette carte et des plages de contact externes, ce procédé comprenant les étapes suivantes:
- fabrication d'un connecteur externe présentant à sa face externe lesdites plages de contact externes et à sa face interne, opposée à la face externe, une pluralité de plages de contact internes;
- fabrication du corps de carte avec une cavité prévue pour le connecteur, l'unité électronique et/ou l'antenne étant reliées électriquement à une deuxième pluralité de plages de contact apparaissant à une surface de la cavité prévue dans le corps de la carte;
- apport du connecteur et d'une colle dans la cavité, les première et deuxième pluralités de plages de contact étant agencées de manière à être situées l'une en face de l'autre lorsque ce connecteur est introduit dans la cavité;
- apport de chaleur au travers du connecteur pour effectuer un soudage de la première pluralité de plages de contact à la deuxième pluralité de plages de contact, les plages de contact de la première pluralité et/ou les plages de contact de la deuxième pluralité étant configurées et/ou une brasure intermédiaire étant localement déposée sur la première et/ou la deuxième pluralité de plages de contact de manière à compenser l'épaisseur de la colle située entre la surface de la cavité et la face interne du connecteur une fois ce dernier fixé au corps de la carte.

Grâce aux caractéristiques de la carte électronique selon l'invention et au procédé de fabrication selon l'invention permettant d'obtenir une telle carte, les connections électriques entre le connecteur externe et les plages de contact de l'unité électronique et/ou de l'antenne incorporée dans le corps de la carte sont effectuées au moyen de soudures qui présentent une grande longévité étant donné qu'elles sont susceptibles de supporter de multiples contraintes mécaniques sans que les connections électriques ne soient rompues. En effet, de telles connections électriques sont relativement robustes étant donné qu'une soudure est bien plus résistante qu'un collage effectué au moyen d'une colle conductrice comme dans l'art antérieur mentionné précédemment.

### Brève description des dessins

Des modes de mise en oeuvre du procédé de fabrication selon l'invention ainsi que des modes de réalisation de cartes électroniques selon l'invention seront décrits ci-après à l'aide de la description détaillée suivante, faite en référence aux dessins annexés, donnés à titre d'exemples nullement limitatifs, dans lesquels:
- les figures 1A et 1B, déjà décrites, montrent schématiquement un procédé de fabrication classique de cartes électroniques de l'art antérieur ;
- la figure 2, déjà décrites, est une coupe partielle d'une carte de l'art antérieur;
- la figure 3 montre schématiquement les divers éléments; intervenant dans un premier mode de mise en oeuvre du procédé de fabrication selon l'invention;
- les figures 4A et 4B montrent respectivement deux étapes du premier mode de mise en oeuvre du procédé de fabrication selon l'invention;
- la figure 5 est une coupe partielle d'un premier mode de réalisation d'une carte électronique selon l'invention;
- la figure 6 montre une étape d'une variante du premier mode de mise en oeuvre du procédé selon l'invention;
- la figure 7 est une coupe partielle d'un deuxième de mode de réalisation d'une carte selon l'invention;
- les figures 8A à 8F montrent schématiquement les diverses étapes d'un deuxième mode de mise en oeuvre du procédé de fabrication selon l'invention;
- la figure 9 est une coupe partielle d'un troisième mode de réalisation d'une carte selon l'invention;
- la figure 10 est une vue de dessus d'un mode de réalisation préféré d'un connecteur externe selon l'invention; et
- la figure 11 est une vue en coupe, selon la ligne XI-XI, du connecteur externe de la figure 10.

### Description détaillée de l'invention

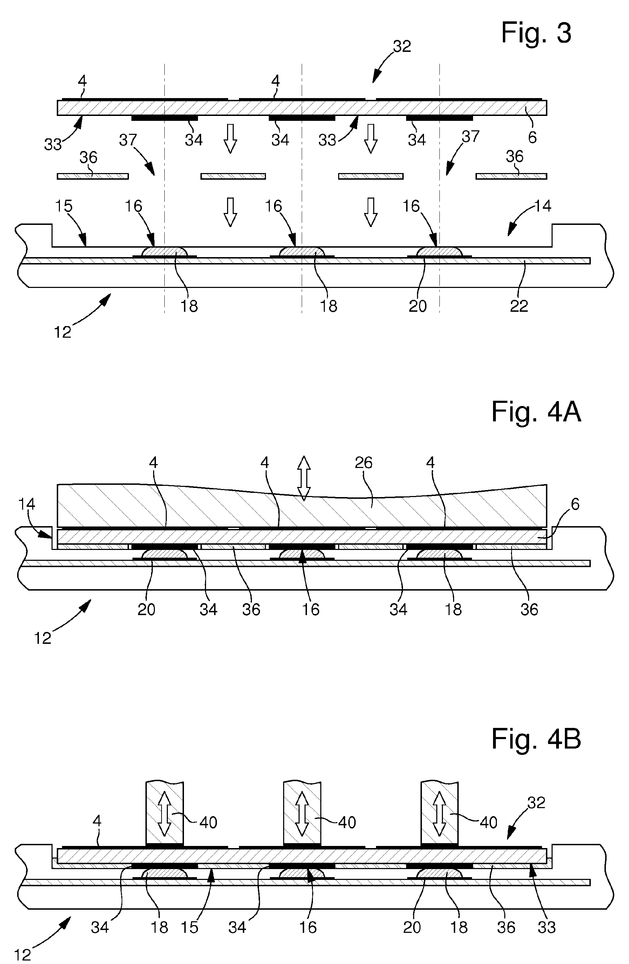

A l'aide des figures 3, 4A et 4B, on décrira ci-après un premier mode de mise en oeuvre d'un procédé de fabrication de cartes électroniques selon l'invention. Les références déjà décrites précédemment ne seront pas décrites ici à nouveau en détail. A la figure 3 sont représentées trois éléments distincts intervenant dans la fabrication de la carte électronique. Il s'agit du connecteur externe 32, du film de colle ajouré 36 et du corps de carte 12 similaire à celui décrit précédemment.

Le connecteur externe 32 définit un premier mode de réalisation d'un connecteur externe selon la présente invention. Il comprend un support 6 à la face externe duquel sont agencées des plages de contact externe 4. Sur la face interne 33 du support 6 est agencée une première pluralité de plages de contact internes 34. Selon ce premier mode de réalisation du connecteur externe, la première pluralité de internes 34 est formée de contacts métalliques dont l'épaisseur est prévue sensiblement égale à l'épaisseur du film de colle 36. Le film de colle thermocollante 36 présente une pluralité d'ouvertures 37 dont l'agencement correspond à la première pluralité de plages de contact internes 34 du connecteur externe 32. Le corps de carte 12, dans lequel est incorporé au moins une unité électronique et/ou une antenne (non représentées sur les figures) présente une cavité 14 prévue pour le connecteur 32. A la surface 15 de cette cavité apparait une deuxième pluralité de plages de contact 16 reliées électriquement à ladite unité électronique et/ou ladite antenne incorporée dans le corps de carte.

Pour assembler le connecteur 32 au corps de carte 12, il est prévu selon l'invention d'apporter un film de colle ajouré 36 qui est agencé contre la surface 15 de la cavité 14. Ensuite, le connecteur externe 32 est apporté dans la cavité avec sa face interne 33 en appui contre le film de colle 36. Les première et deuxième pluralités de plages de contact 34 et 16 sont agencées de manière à être situées l'une en face de l'autre lorsque le connecteur 32 est introduit dans la cavité 14. Dans la variante décrite ici, la deuxième pluralité de plages de contact 16 est prévue sensiblement en niveau de la surface 15 de la cavité 14. Le film de colle 36 est découpé sensiblement aux dimensions de la cavité 14 qui sont sensiblement ajustées à celles du support 6. Les ouvertures 37 prévues dans le film de colle 36 sont réalisées de manière à ce que ces ouvertures soient alignées sur les paires de plages de contact correspondantes 16 et 34 situées l'une en face de l'autre. Les ouvertures 37 présentent des dimensions égales ou légèrement supérieures à celles des plages de contact internes correspondantes 34. On apporte ainsi séparément le connecteur 32 et le film de colle 36 dans la cavité 14, la première pluralité de plages de contact 34 étant introduite dans les ouvertures 37 du film de colle 36. Selon l'invention, les plages de contact internes 34 sont en appui contre les plages de contact 16 du corps de carte 12 ou situées à très faible distance de celles-ci. A l'aide d'une presse chauffante 26, on effectue ensuite un collage du connecteur externe 32 à la surface 15 de la cavité 14, c'est-à-dire au fond de cette cavité. Une pression suffisante est exercée sur le connecteur 32 pour assurer un contact physique entre les contacts métalliques 34 et les plages correspondantes 16. La cavité 14 définit ainsi un logement pour le connecteur 32 qui adhère à la surface 15 de cette cavité au moyen de la colle 36 située entre cette surface 15 et la face interne 33 du connecteur 32.

On notera ici que dans toutes les variantes décrites, la colle prévue est apportée sous la forme d'un film de colle thermocollante. Cependant, dans d'autres variantes non décrites, cette colle peut être amenée d'autres manières, notamment sous la forme d'un liquide visqueux ou de pâte déposée dans certaines zones de la face interne 33 du support 6 ou de la surface 15 définie par le fond de la cavité 14. Toutefois, ces dernières variantes sont délicates étant donné qu'il est prévu selon l'invention que la colle ne recouvre pas les contacts métalliques épais 34 définissant la première pluralité de plages de contact internes dans le premier mode de mise en oeuvre du procédé selon l'invention décrite ici.

Selon une variante particulière, les plages de contact internes 34 du connecteur 32 sont réalisées par un dépôt galvanique sur des plages métalliques d'un circuit imprimé sur la face interne 33 de ce connecteur.

Dans la variante décrite ici, la deuxième pluralité de plages de contact 16 est formée par une brasure 18 déposée sur une troisième pluralité de plages de contact 20 agencée à la surface d'un support 22 associée à l'unité électronique et/ou l'antenne incorporés dans le corps de carte 12.

Une fois le connecteur 32 collé dans la cavité 14 au moyen d'une presse chauffante 26, la colle 36 entoure les contacts métalliques épais 34. Ces contacts métalliques après l'étape de collage sont en appui contre les plages de contact 16. Selon l'invention, il est alors prévu un apport de chaleur au travers du connecteur 32 pour effectuer un soudage de la première pluralité de plages de contact 34 à la deuxième pluralité de plages de contact 16. Un tel soudage peut être réalisé aisément étant donné que les plages 16 définies par une brasure 18 sont en contact direct avec les contacts métalliques épais 34. Le transfert de chaleur, pour fondre au moins partiellement la partie supérieure des gouttes de brasure tronquées 18, est donc réalisé au travers des contacts métalliques épais 34 qui sont en contact direct avec les plages de contact correspondantes 16. De préférence, cet apport de chaleur est effectué de manière localisée au moyen de thermodes 40 d'un dispositif de soudage approprié.

Grâce aux caractéristiques de l'invention, la première pluralité de plages de contact internes est configurée de manière à compenser l'épaisseur de la colle 36 située entre la surface 15 de la cavité 14 et la face interne 33 du connecteur 32, une fois ce connecteur fixé au corps de carte 12. Ainsi, dans la variante décrite ici, l'apport de chaleur, pour effectuer le soudage, des paires de plages de contact 34 et 16, est effectué de manière localisée pour chacune de ces paires de plage de contact. Cet apport de chaleur localisé est prévu de manière à ne pas endommager le corps de carte 12, en particulier pour éviter des déformations de celui-ci.

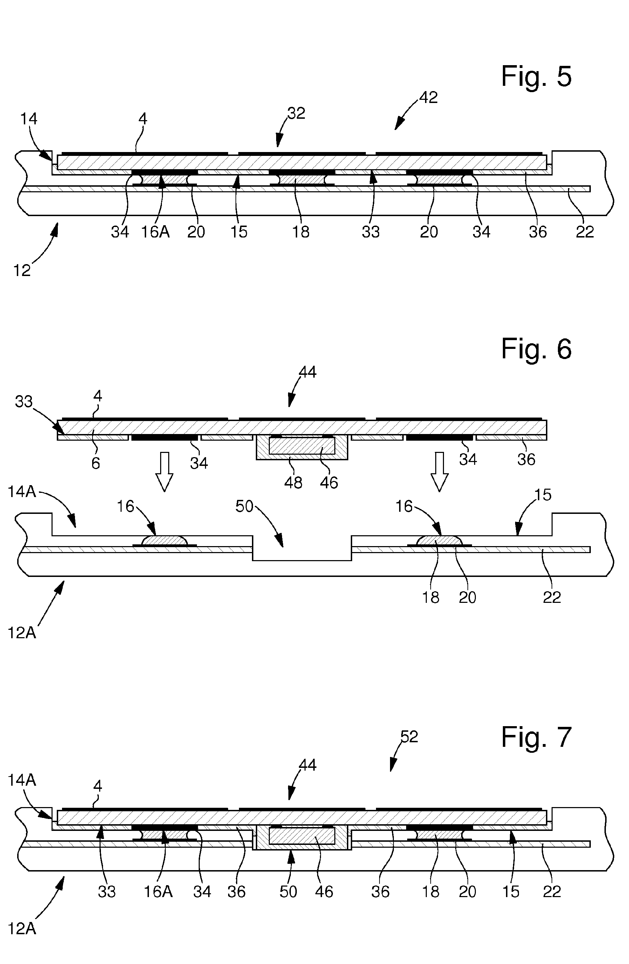

Le procédé de fabrication selon l'invention décrit ci-avant permet d'obtenir un premier mode de réalisation d'une carte électronique 42 selon l'invention, laquelle est représentée partiellement en coupe à la figure 5. Les plages de contact externes 4 sont reliées électriquement aux contacts métalliques épais 34. Ainsi, le connecteur externe 32 permet à un lecteur à contacts résistifs d'accéder à l'unité électronique incorporée dans la carte 42. Cette carte 42 est caractérisée par le fait que la première pluralité de plages de contact internes 34 du connecteur externe sont respectivement soudées aux plages de contact 16,16A de la seconde pluralité des plages de contact agencées au niveau du fond 15 de la cavité 14. La soudure réalisée entre chaque plage de contact interne du connecteur 32 et la plage de contact correspondante 20 agencée à la surface du support 22 garantit une connexion électrique robuste entre le connecteur externe et l'unité électronique et/ou l'antenne incorporée dans le corps 12 de la carte 42. Un tel soudage assure une forte liaison entre les plages de contact 34 et les plages de contact 20.

On remarquera que l'apport de chaleur localisé, pour effectuer le soudage des contacts métalliques 34 aux plages de contact correspondantes 20, fait également fondre localement le matériau formant le corps de carte 12A de sorte que la goutte de brasure 18 peut prendre une forme légèrement différente, en particulier dû à la présence du contact métallique 34, de sorte que cette brasure 18 présente une surface 16A de liaison au contact 34 qui diffère de la surface définie par la plage de contact initiale 16.

A la figure 6 est représentée une variante du premier mode de mise en oeuvre du procédé selon l'invention et à la figure 7 est représenté partiellement en coupe un deuxième mode de réalisation d'une carte électronique 52 selon l'invention. Les références déjà décrites précédemment ne seront pas écrites ici à nouveau en détail. Cette variante concerne un connecteur externe 44 qui comprend sur sa face interne 33 un circuit électronique 46, notamment un circuit intégré, enrobé dans une résine 48. Ce connecteur externe 44 définit ainsi un module électronique du type utilisé dans les cartes bancaires à contacts résistifs externes. En particulier, la variante de réalisation des figures 6 et 7 concernent une carte connue sous le terme anglais "dual interface", c'est-à-dire une carte électronique pouvant communiquer avec un lecteur à contact résistif et également avec un lecteur sans contact au moyen d'une antenne agencée dans le corps de carte 12A. Ainsi, par exemple, les deux plages de contact 16 apparaissant à la surface 15 de la cavité 14A définissent deux plages de contact d'une antenne agencée sur ce support 22 et incorporée dans le corps de carte 12A. Pour permettre de loger le circuit intégré 46 et son enrobage de protection 48, la cavité 14A comprend un évidement inférieur 50 sensiblement aux dimensions de l'enrobage 48. Cet évidement 50 peut notamment traverser le support 22 comme représentées aux figures 6 et 7.

Les plages de contact internes 34 du connecteur 44 sont réalisées notamment de la même manière que celles du connecteur 32 décrit précédemment; c'est-à-dire par un dépôt galvanique effectué sur des plages métalliques de faible épaisseur agencée sur la face interne 33 du connecteur. Un tel dépôt galvanique permet ainsi d'obtenir des contacts métalliques 34 présentant une épaisseur sensiblement égale à celle du film de colle ajouré 36. Les autres étapes du procédé selon la variante décrite ici sont similaires à celles décrites précédemment à l'aide des figures 3, 4A et 4B.

Les plages de contact externes 4 du connecteur 44 de la carte électronique 52 sont, dans une première variante, connectées d'une part au circuit intégré 46 et, d'autre part, à une unité électronique incorporée dans le corps de carte 12A. Dans une autre variante, dans le cas d'une carte moins complexe dans laquelle seule une antenne est incorporée dans le corps de carte, l'ensemble des plages externes 4 sont reliées au circuit intégré 46. Les contacts métalliques 34 agencées à la face interne 33 du connecteur 44 sont connectées via un circuit imprimé sur cette face interne au circuit électronique 46 et, par l'intermédiaire des plages de contact 20 soudées à ces contacts métalliques 34, à une antenne incorporée dans le corps de carte 12A.

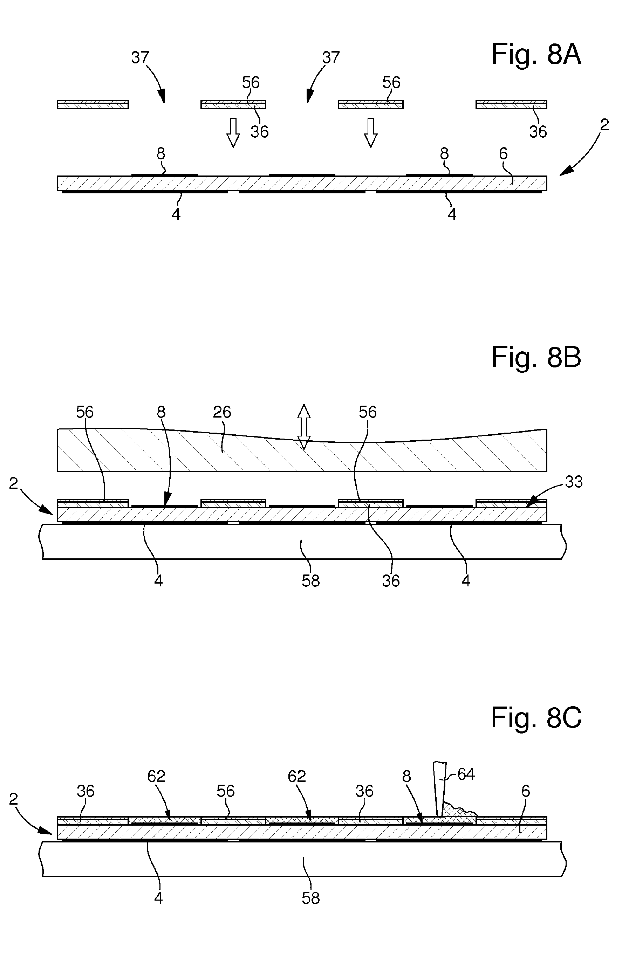

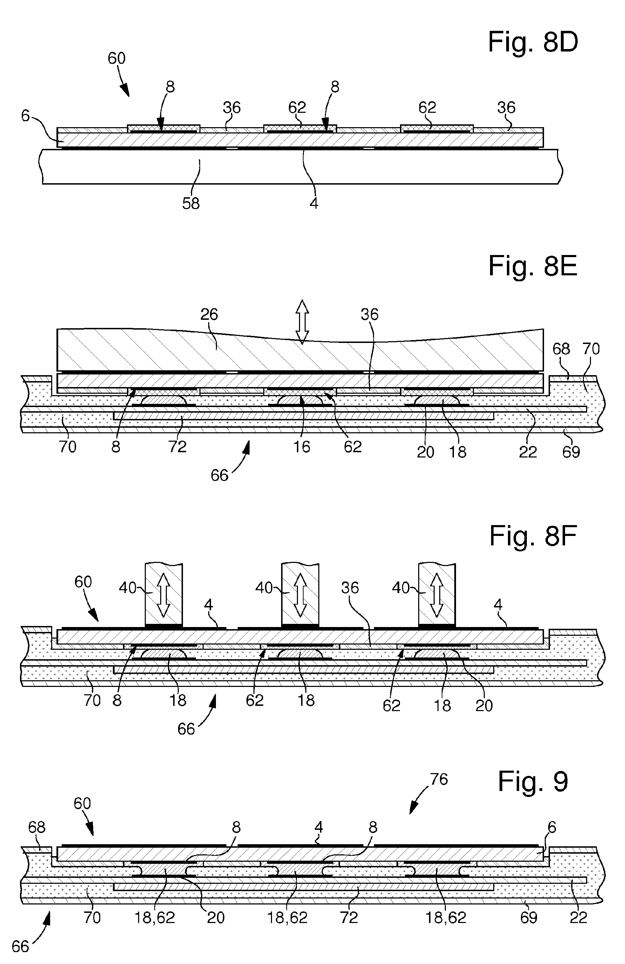

A l'aide des figures 8A à 8F on décrira ci-après un deuxième mode de mise en oeuvre du procédé de fabrication de cartes électroniques selon l'invention. Les références déjà décrites précédemment ne seront pas décrites ici à nouveau en détail. Dans une première étape, on apporte sur la face interne 33 d'un connecteur externe classique 2 un film de colle ajourée 36 présentant une pluralité d'ouvertures 37 correspondante à la pluralité de plages de contact interne 8 agencée sur cette face interne 33. Dans la variante décrite ici, le film de colle ajouré 36 est apporté avec une feuille détachable 56 qui lui sert de support. Cette feuille détachable 56 adhère faiblement au film de colle 36 et présente les mêmes ouvertures que ce dernier. Le film de colle 36 est posé sur la face interne 33 de manière que manière que les plages de contact internes 8 soient situées dans les ouvertures correspondantes 37 de ce film de colle. La feuille détachable 56 est située de l'autre côté de la face 33 relativement au film de colle 36; d'est à dire au dessus de celui-ci. Elle forme donc une couche de protection supérieure dont une première fonction intervient à l'étape suivante représentée schématiquement à la figure 8D. Dans cette étape, le film de colle 36 est appliqué contre la face interne 33 à l'aide d'une presse chauffante 26 de manière que ce film de colle 36 adhère correctement au support 6 du connecteur 2.

Ensuite, il est prévu dans l'étape suivante, représentée schématiquement à la figure 8C, d'apporter une brasure 62, notamment une pâte d'étain dans les ouvertures 37 du film de colle 36. Etant donné que la feuille détachable 56 est de préférence laissée sur le film de colle ajouré 36 dans cette étape de remplissage des ouvertures 37 par une brasure, les ouvertures de cette feuille détachable peuvent également être remplies au moins partiellement par la brasure. Dans la variante représentée à la figure 8C, la brasure est apportée avec un léger excès dans les ouvertures puis, à l'aide d'une lame 64, le surplus est enlevé et les surfaces externes de la brasure 62 sont aplanies. Lors de cette opération, selon la pression exercée par la lame 64 sur la feuille détachable 56, les ouvertures de cette dernière seront remplies seulement partiellement étant donné une légère dépression résultant de cette étape d'égalisation de la brasure. Dans une variante particulière, la brasure est apportée par un dispositif muni d'au moins une buse, ce dispositif déposant dans chaque ouverture 37 une dose de brasure correspondant au moins au volume défini par cette ouverture. Selon une variante préférée, la dose de brasure apportée correspond précisément à une quantité de brasure prédéterminée prévue pour réaliser le soudage de chaque paire de plages de contact correspondantes. Dans ce dernier cas, il n'est donc pas nécessaire d'enlever un surplus avec une lame ; ce qui constitue un avantage.

La deuxième fonction de la feuille détachable 56 est la protection du film de colle lors de l'apport de la brasure 62 et en particulier lors de l'étape facultative d'égalisation de l'épaisseur de cette brasure à l'aide de la lame 64 qui se déplace horizontalement sur cette feuille.

Une fois la brasure apportée dans les ouvertures du film de colle 36, la feuille 56 est détachée et/ou obtient le produit intermédiaire 60 représenté à la figure 8D. Le produit intermédiaire 60 forme un deuxième mode de réalisation d'un connecteur externe selon la présente invention. Il comprend un substrat 6 sur une première face duquel sont agencées les plages de contact externes 4. Sur la seconde face du support 6 sont agencées des plages de contact 8 et le film de colle thermocollante 36 dont les ouvertures sont alignées sur les plages de contact 8. Au-dessus des plages de contact 8, dans les ouvertures du film de colle 36, est prévu une brasure 62, notamment une pâte d'étain. Dans la variante représentée à la figure 8D, la brasure 62 présente une surface supérieure légèrement au-dessus de la surface du film de colle 36, dû à la présence de la feuille détachable 56 lors de la fabrication de ce connecteur 60.

Dans une étape ultérieure du deuxième mode de mise en oeuvre du procédé de fabrication selon l'invention, il est prévu d'apporter le connecteur externe 60 dans une cavité du corps de carte 66. Comme dans le premier mode de mise en oeuvre écrit précédemment, des plages de contact 16, formées par une brasure 18 déposées sur des plages de contact 20 internes au corps de carte 66, apparaissent à la surface du fond de la cavité. La pluralité de plages contact 16 est agencée de manière à être située en face de la pluralité de plages de contact internes 8 du connecteur 60. La brasure 62 déposée dans les ouvertures du film de colle 36 est directement posée sur les plages de contact 16 du corps de carte 66. Une presse chauffante 26 est utilisée pour comprimer la brasure 62, ce qui est utile en particulier lorsque cette brasure est formée par une pâte. La pression exercée par ledit dispositif 26 et la chaleur fournie par celui-ci permettent premièrement d'appliquer le film de colle 36 contre la surface horizontale du fond de la cavité et ensuite d'assurer une bonne adhérence de ce film de colle au corps de cartes 66. La presse chauffante 26 est retirée et, dans la variante décrite ici, un dispositif de soudage comprenant une pluralité de thermodes 40 est utilisé pour effectuer l'étape de soudage représentée schématiquement à la figure 8F. On remarquera que les thermodes 40 sont appliquées contre des zones des plages de contact externes 4, ces thermodes 40 étant respectivement alignées sur les paires de plages de contact correspondantes 8 et 20 entre lesquelles sont situées les brasures 18 et 62 superposées l'une à l'autre. La brasure 62 déposée localement dans les ouvertures du film de colle définit une couche intermédiaire entre les deux plages de contact à connecter de manière à compenser l'épaisseur du film de colle 36 qui est situé entre la surface du fond de la cavité dans le corps de carte et la face interne du connecteur 60 une fois ce dernier fixé au corps de carte.

Les thermodes 40 apportent de manière locale une chaleur suffisante pour fondre la brasure 18 et la brasure 62 entre les paires de plages de contact correspondantes. Suite à cette opération de soudage, on obtient un troisième mode de réalisation d'une carte électronique selon l'invention représenté partiellement en coupe à la figure 9.

Dans la variante décrite ci-avant, le collage du connecteur externe est réalisé par une presse chauffante 26 et le soudage des plages de contact internes du connecteur deux plages de contact du corps de carte est prévu dans une étape ultérieure à l'aide d'un dispositif de soudage spécifique. Dans une variante de mise en oeuvre du procédé de l'invention, il est prévu d'effectuer ces deux étapes de manière combinée à l'aide d'un dispositif capable de fournir d'une part la chaleur nécessaire au collage, lequel s'effectue par exemple entre 100 et 150°C, et d'autre part de fournir de manière localisée aux plages de contact internes du connecteur une chaleur suffisante pour effectuer le soudage prévu, par exemple à une température comprise entre 500 et 600°C.

La carte électronique 76 selon l'invention, obtenue notamment à l'aide du deuxième mode de mise en oeuvre du procédé de fabrication selon l'invention, est caractérisée par une connexion de la pluralité de plages de contact internes 8 à la pluralité de plages de contact correspondantes 20 au moyen de soudures formées par les brasures 18 et 62 fondues est amalgamées de manière à former des ponts métalliques rigides entre les paires de plages de contact correspondantes. Les brasures 18 et 62 sont formées de préférence d'étain; mais dans d'autres variantes, la soudure peut également être réalisée avec du cuivre.

Dans la variante représentée à la figure 9, la première pluralité de plages de contact internes est formée de plages métalliques agencées sur la face interne du support du connecteur. Ces plages métalliques ont une épaisseur inférieure à celle de la couche de colle. Les zones entre cette première pluralité de contact internes 8 et la troisième pluralité de plages de contact 20 sont remplies d'une brasure entourée partiellement par la colle. Cette brasure forme une soudure entre chaque paire de plages de contact correspondantes soudées l'une à l'autre. Dans une autre variante dans laquelle la deuxième pluralité de plages de contact 16 n'est pas réalisée avec de la brasure, mais avec un métal comme le cuivre. La première pluralité de plages de contact internes est toujours formée de plages métalliques ayant une épaisseur inférieure à celle de la colle. Selon l'invention, les zones entre cette première pluralité de contact internes et la deuxième pluralité de plages de contact sont remplies d'une brasure entourée par la colle, cette brasure formant une soudure entre chaque paire de plages de contact correspondantes soudées l'une à l'autre.
ladite première pluralité de plages de contact internes est formée de plages métalliques agencées sur la face interne dudit support du connecteur et ayant une épaisseur inférieure à celle de ladite colle, les zones entre cette première pluralité de contact internes et ladite troisième pluralité de plages de contact étant remplies d'une brasure entourée partiellement par ladite colle, cette brasure formant une soudure entre chaque paire de plages de contact correspondantes soudées l'une à l'autre.

La première pluralité de plages de contact internes est formée de plages métalliques 8 agencées sur la face interne du support du connecteur et ayant une épaisseur inférieure à celle du film de colle. Cependant, selon l'invention, les espaces restant dans les ouvertures du film de colle entre cette première pluralité de contact internes et la deuxième pluralité de plages de contact sont remplies d'une brasure entourée par la colle, cette brasure formant une soudure fiable et robuste entre chaque paire de plages de contact correspondantes soudées l'une à l'autre.

Le corps de carte 66 est formé d'une couche intermédiaire de résine 70 située entre deux couches externes 68 et 69. Le support 22, à la surface duquel sont agencées les plages de contact 20 et les gouttes de brasure 18, est enrobée par la résine 70. Cette résine 70 enrobe également d'autres éléments de la carte en fabrication, notamment l'unité électronique et/ou l'antenne (non représentées) incorporées dans la carte électronique selon l'invention. Selon une variante de réalisation préférée, il est prévu au dos du support 22 d'agencer une couche solide 72 dont la fonction est de positionner en hauteur le support 22 et donc les gouttes de brasure 18 dans la couche intermédiaire de résine. Ceci permet d'assurer que les plages de contact 16, définies par les gouttes de brasure tronquées, affleurent la surface du fond de la cavité lors de l'usinage ce cette cavité. En effet, on comprend que la profondeur de la cavité est définie par l'épaisseur du connecteur externe. Dans le cas d'une fabrication à l'aide d'une résine 70 apportée dans un état non solide, notamment liquide visqueux ou pâteux, il a été observé que le substrat 22 a une tendance de descendre dans la résine et reste alors relativement proche de la couche solide inférieure 69. Ceci pose un problème notamment dans la fabrication de cartes complexes utilisant des résines apportées dans un état non solide pour enrober les divers éléments et unités prévus. Grâce à la couche solide additionnelle 72 prévue au dos du support 22, il est possible de positionner de manière relativement précise dans l'épaisseur de la couche de résine le support 22 et donc les gouttes de brasure s'élevant des plages de contact 20.

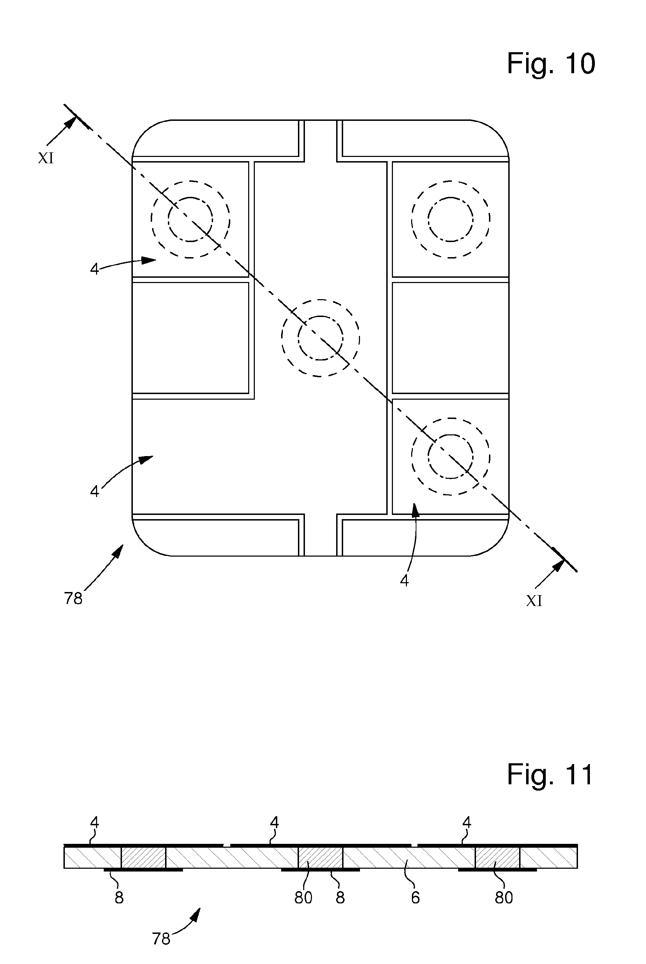

Aux figures 10 et 11 est représenté de manière schématique un mode de réalisation préféré d'un connecteur externe selon l'invention. Ce connecteur 78 présente de manière classique des plages de contact externes 4 sur la face externe du support 6 et des plages de contact internes 8 sur la face interne de ce support 6. Selon l'invention, des vias métalliques 80 de relativement grand diamètre sont prévus entre les plages de contact externes 4 et les plages de contact internes 8. Ces vias métalliques servent premièrement à la connexion électrique des plages externes 4 aux plages internes 8. Ensuite, ces vias 80 sont superposés aux plages de contact internes 8 pour favoriser l'étape de soudage de ces plages de contact aux plages de contact correspondantes du corps de carte, comme décrit précédemment. En effet, ce substrat 6 est formé d'un matériau isolant qui généralement conduit mal la chaleur. Par contre, les vias métalliques 80 conduisent très bien la chaleur. Ainsi, la chaleur apportée au moyen du dispositif de soudage spécifique décrit précédemment est canalisée par les vias 80 en direction des plages de contact internes 8 et de la brasure prévue en-dessous de celles-ci pour effectuer le soudage aux plages de contact internes du corps de carte. Grâce à l'agencement de vias 80, tel que représenté à la figure 11, il est ainsi possible d'apporter moins de chaleur lors l'étape de soudage et donc d'éviter des déformations locales du corps de carte dû à cet apport de chaleur, lequel engendre des températures élevées pour les matériaux plastiques ou la résine formant le corps de carte.

## Revendications

1. Carte électronique comprenant une unité électronique et/ou une antenne incorporée dans le corps de cette carte et un connecteur externe présentant, d'une part, des plages de contact externes agencées sur une face externe d'un support formant le connecteur et, d'autre part, des plages de contact internes agencées sur une face interne dudit support opposée à la face externe, au moins une première pluralité de plages de contact internes dudit connecteur étant respectivement reliées électriquement à une deuxième pluralité de plages de contact de ladite unité électronique et/ou de ladite antenne qui apparaissent à une surface d'une cavité prévue dans ledit corps de la carte, cette cavité définissant un logement pour ledit connecteur qui adhère à ladite surface de cette cavité au moyen d'une colle située entre cette surface et ladite face interne du connecteur, **caractérisé en ce que** les plages de contact internes de ladite première pluralité de plages de contact internes sont respectivement soudées aux plages de contact de ladite seconde pluralité de plages de contact.

2. Carte électronique selon la revendication 1, **caractérisée en ce que** ladite deuxième pluralité de plages de contact est formée d'une brasure déposée sur une troisième pluralité de plages de contact agencées à la surface d'un support interne audit corps de carte, cette troisième pluralité de plages de contact étant reliée électriquement à ladite unité électronique et/ou à ladite antenne.

3. Carte électronique selon la revendication 1 ou 2, **caractérisée en ce que** ladite première pluralité de plages de contact internes est formée de contacts métalliques dont l'épaisseur est prévue sensiblement égale à l'épaisseur de ladite colle, laquelle ne recouvre pas ces contacts métalliques, ladite deuxième pluralité de plages de contact étant prévue sensiblement au niveau de ladite surface de ladite cavité.

4. Carte électronique selon la revendication 1, **caractérisée en ce que** ladite première pluralité de plages de contact internes est formée de plages métalliques agencées sur la face interne dudit support du connecteur et ayant une épaisseur inférieure à celle de ladite colle, les zones entre cette première pluralité de contact internes et ladite deuxième pluralité de plages de contact étant remplies d'une brasure entourée par ladite colle, cette brasure formant une soudure entre chaque paire de plages de contact correspondantes soudées l'une à l'autre.

5. Carte électronique selon la revendication 2, **caractérisée en ce que** ladite première pluralité de plages de contact internes est formée de plages métalliques agencées sur la face interne dudit support du connecteur et ayant une épaisseur inférieure à celle de ladite colle, les zones entre cette première pluralité de contact internes et ladite troisième pluralité de plages de contact étant remplies d'une brasure entourée partiellement par ladite colle, cette brasure formant une soudure entre chaque paire de plages de contact correspondantes soudées l'une à l'autre.

6. Carte électronique selon l'une quelconque des revendications précédentes, **caractérisée en ce qu'**au moins une partie des plages externes du connecteur sont reliées électriquement à ladite première pluralité de plages de contact internes par des vias respectivement agencés entre ces plages externes et cette première pluralité de plages de contact internes.

7. Carte électronique selon l'une quelconque des revendications précédentes, **caractérisée en ce qu'**elle comprend en outre un circuit intégré agencé sur ladite face interne du support dudit connecteur et formant avec ce dernier un module électronique situé dans ladite cavité du corps de la carte.

8. Procédé de fabrication d'une carte électronique comprenant au moins une unité électronique et/ou une antenne incorporée dans le corps de cette carte et des plages de contact externes, comprenant les étapes suivantes :
- fabrication d'un connecteur externe présentant à sa face externe lesdites plages de contact externes et à sa face interne, opposée à la face externe, une première pluralité de plages de contact internes;
- fabrication dudit corps de carte avec une cavité prévue pour ledit connecteur, ladite unité électronique et/ou ladite antenne étant reliées électriquement à une deuxième pluralité de plages de contact apparaissant à une surface de la cavité ;
- apport dudit connecteur et d'une colle dans ladite cavité, lesdites première et deuxième pluralités de plages de contact étant agencées de manière à être situées l'une en face de l'autre lorsque ce connecteur est introduit dans la cavité ;
- apport de chaleur au travers dudit connecteur pour effectuer un soudage de ladite première pluralité de plages de contact à ladite deuxième pluralité de plages de contact, les plages de contact de ladite première pluralité et/ou les plages de contact de ladite deuxième pluralité étant configurées et/ou une brasure intermédiaire étant localement déposée sur ladite première et/ou deuxième pluralité de plages de contact de manière à compenser l'épaisseur de ladite colle située entre la surface de la cavité et ladite face interne du connecteur une fois ce connecteur fixé au corps de la carte.

9. Procédé de fabrication d'une carte électronique selon la revendication 8, **caractérisé en ce que** ladite deuxième pluralité de plages de contact est formée d'une brasure déposée sur une troisième pluralité de plages de contact agencées à la surface d'un support interne audit corps de carte, cette troisième pluralité de plages de contact étant reliées électriquement à ladite unité électronique et/ou à ladite antenne.

10. Procédé de fabrication d'une carte électronique selon la revendication 8 ou 9, **caractérisé en ce que** ladite colle est apportée sous la forme d'un film de colle thermocollante ayant une pluralité d'ouvertures correspondant à ladite première pluralité de plages de contact internes, ce film de colle étant chauffé après l'étape d'apport du connecteur et de ce film de colle dans ladite cavité pour fixer ce connecteur audit corps de la carte.

11. Procédé de fabrication d'une carte électronique selon la revendication 10, **caractérisé en ce que** ledit film de colle thermocollante est apporté séparément dudit collecteur dans ladite cavité.

12. Procédé de fabrication d'une carte électronique selon la revendication 10, **caractérisé en ce que** ledit film de colle thermocollante est assemblé audit collecteur préalablement à leur apport dans ladite cavité.

13. Procédé de fabrication d'une carte électronique selon l'une quelconque des revendications 8 à 12, **caractérisée en ce que** ladite première pluralité de plages de contact internes est formée de contacts métalliques dont l'épaisseur est sensiblement égale à l'épaisseur de ladite colle une fois le connecteur fixé dans ladite cavité, cette colle ne recouvrant pas les contacts métalliques, ladite deuxième pluralité de plages de contact étant agencée sensiblement au niveau de ladite surface de cette cavité.

14. Procédé de fabrication d'une carte électronique selon la revendication 13, **caractérisé en ce que** ladite première pluralité de plages de contact internes est réalisée par un dépôt galvanique sur des plages métalliques formées par un circuit imprimé sur la face interne du connecteur.

15. Procédé de fabrication d'une carte électronique selon la revendication 12, **caractérisé en ce que** qu'une brasure est apportée dans lesdites ouvertures du film de colle thermocollante avant l'apport dudit collecteur dans ladite cavité.

16. Procédé de fabrication d'une carte électronique selon la revendication 15, **caractérisé en ce que** le film de colle apporté est apportée avec une feuille détachable auquel il adhère faiblement, cette feuille détachable étant située du côté opposé à la face interne du connecteur relativement au film de colle, cette feuille détachable ayant également, en face desdites ouvertures du film de colle, des ouvertures correspondantes, et **en ce que** l'apport de ladite brasure est réalisé avant l'enlèvement de la feuille détachable dudit connecteur.

17. Procédé de fabrication d'une carte électronique selon la revendication 15 ou 16, **caractérisé en ce que** ladite brasure est apportée par un dispositif muni d'au moins une buse, ce dispositif déposant dans chaque ouverture une dose de brasure correspondant au moins au volume défini par cette ouverture.

18. Procédé de fabrication d'une carte électronique selon la revendication 17, **caractérisé en ce que** ladite dose de brasure apportée correspond précisément à une quantité de brasure prédéterminée prévue pour réaliser ledit soudage de chaque paire de plages de contact correspondantes.

19. Procédé de fabrication d'une carte électronique selon l'une quelconque des revendications 8 à 18, **caractérisé en ce que** l'apport de chaleur pour effectuer ledit soudage des paires de plages de contact correspondantes est effectué de manière localisée pour chaque plage de contact de ladite première pluralité de plages de contact internes.

20. Procédé de fabrication d'une carte électronique selon l'une des revendications 8 à 19, **caractérisé en ce qu'**au moins une partie des plages externes du connecteur sont reliées électriquement à ladite première pluralité de plages de contact internes par des vias métalliques respectivement agencés entre ces plages externes et ces plages de contact internes, ces vias métalliques servant également de conducteur de chaleur au travers dudit connecteur lors dudit soudage.
